(19) Europäisches Patentamt
European Patent Office
Office européen des brevets

(11) Publication number: **0 043 699**
**B1**

(12) **EUROPEAN PATENT SPECIFICATION**

(45) Date of publication of patent specification: **07.12.83**

(51) Int. Cl.$^3$: **H 03 F 3/30**

(21) Application number: **81303003.8**

(22) Date of filing: **01.07.81**

# (54) Operational amplifier.

(30) Priority: **04.07.80 JP 91370/80**

(43) Date of publication of application:
**13.01.82 Bulletin 82/2**

(45) Publication of the grant of the patent:
**07.12.83 Bulletin 83/49**

(84) Designated Contracting States:
**DE FR GB NL**

(56) References cited:
**WO - A - 81/00938**
**US - A - 4 163 908**

**IEEE JOURNAL OF SOLID-STATE CURCUITS, Vol. SC-14, No. 6, December 1979 New York, I.A. YOUNG "A High-Performance All-Enhancement NMOS operational Amplifier" pages 1070 to 1077**

**IEEE JOURNAL OF SOLID-STATE CIRCUITS, Vol. SC-14, No. 6, December 1979 New York, B.J. WHITE et al. "A Monolithic Dual Tone Multifrequency Receiver" pages 991 to 997**

(73) Proprietor: **FUJITSU LIMITED**
**1015, Kamikodanaka Nakahara-ku**
**Kawasaki-shi Kanagawa 211 (JP)**

(72) Inventor: **Goto, Kunihiko**
**1676-202, Mukaigaoka Takatsu-ku**
**Kawasaki-shi Kanagawa 213 (JP)**
Inventor: **Kobayashi, Kazuhiro**
**7-5, Kitasuna 7-chome**
**Koto-ku Tokyo 136 (JP)**
Inventor: **Ito, Akihiko**
**3780, Suge, Tama-ku**
**Kawasaki-shi Kanagawa 214 (JP)**
Inventor: **Tanaka, Hisami**
**1-17-3-301, Utsukushigaoka Midori-ku**
**Yokohama-shi Kanagawa 227 (JP)**
Inventor: **Saito, Tadahiro**
**532-4, Miyauchi Nakahara-ku**
**Kawasaki-shi Kanagawa 211 (JP)**

(74) Representative: **George, Sidney Arthur et al,**
**GILL JENNINGS & EVERY 53-64 Chancery Lane**
**London WC2A 1HN (GB)**

**EP 0 043 699 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Operational amplifier

This invention relates to an operational amplifier, and more particularly to an operational amplifier having an improved phase-compensating circuit which can prevent high frequency noises on a power supply voltage from being transmitted to an output terminal of the operational amplifier.

In general, an operational amplifier comprises mainly a differential circuit, an output amplifier and a phase-compensating circuit. The phase-compensating circuit of a conventional operational amplifier comprises a capacitor and a buffer amplifier connected in a feedback circuit of the output amplifier and prevents self-oscillation of the operational amplifier by decreasing the high frequency gain thereof.

However, in the conventional operational amplifier, the phase-compensating circuit includes the output amplifier in a part of its signal path, and thus the signal delay time of the phase-compensating circuit is longer than that of the output amplifier. Since the cut-off frequency of a circuit is approximately inversely proportional to the signal delay time of the circuit, the cut-off frequency of the phase-compensating circuit is lower than that of the output amplifier. Therefore, in the frequency range between the cut-off frequencies of the output amplifier and the phase-compensating circuit, the phase-compensating circuit does not operate even though the output amplifier operates, i.e. even though the output amplifier has a gain greater than 1. As a result, noises in the above-mentioned frequency range from the operating voltage source of the operational amplifier appear at the output terminal thereof. Therefore, in the conventional operational amplifier, the supply voltage rejection ratio (SVRR) with regard to the high-frequency noises on the operating voltage source cannot be small, and the conventional operational amplifier requires high-precision ripple filter circuits connected to its operating voltage terminals. Especially in a hybrid type integrated circuit constituted by digital circuits and analog circuits including an operational amplifier, the SVRR of the operational amplifier cannot be small because of the high-frequency noises superposed on the power supply voltage due to operation of the digital circuits.

It is therefore an object of the present invention to provide an operational amplifier having a reduced supply voltage rejection ratio.

According to the present invention, there is provided an operational amplifier comprising a differential circuit which comprises a non-inverting input, an inverting input and an output and which detects the difference between input signals applied to the non-inverting input and the inverting input; an output amplifier the input of which is connected to the output of the differential circuit; an inverting amplifier of a phase-compensating circuit the input of which is connected to the output of the differential circuit; and a phase-compensating capacitor connected between the output of the inverting amplifier and output of the differential circuit, a signal delay time of the inverting amplifier being shorter than that of the output amplifier.

Embodiments of the invention will now be described by way of example, with reference to the accompanying drawings, in which:

Fig. 1A and Fig. 1B are block circuits diagrams illustrating conventional operational amplifiers;

Fig. 2 is a Bode diagram illustrating characteristics of a general operational amplifier

Fig. 3A and Fig. 3B are block circuit diagrams illustrating respective operational amplifiers in accordance with the present invention, and

Fig. 4 is a circuit diagram illustrating the circuit structure of the operational amplifier of Fig. 3A.

Figs. 1A and 1B illustrate examples of conventional operational amplifiers. The operational amplifier of Fig. 1A is constituted by a differential circuit 1 having a non-inverting input terminal $V_{IN}(+)$ and an inverting input terminal $V_{IN}(-)$, a high-gain output amplifier 2, and a phase-compensating circuit comprising a buffer amplifier 3 having unity voltage gain and a phase-compensating capacitor $C_C$ which is connected between an output terminal of the buffer amplifier 3 and an output terminal of the differential circuit 1. The operational amplifier of Fig. 1B is the same as that of Fig. 1A except that the phase-compensating circuit of the operational amplifier of Fig. 1B does not include the buffer amplifier 3 for impedance matching.

In the structure of Fig. 1A, the signal delay time $t_1$ from the output terminal of the differential circuit 1 to the output terminal $V_{OUT}$ of the output amplifier 2 is shorter than the signal delay time $t_2$ from the output terminal of the differential circuit 1 through the output amplifier 2 and the buffer amplifier 3 to the output terminal of the buffer amplifier 3. In the circuit of Fig. 1B, which does not include the buffer amplifier 3, the above-mentioned delay times $t_1$ and $t_2$ are equal to each other. The phase-compensating capacitor $C_C$ operates so as to reduce the high-frequency gain of the operational amplifier and to prevent it from self-oscillation. It should be noted that, in both of the circuits of Figs. 1A and 1B, the capacitance of the capacitor $C_C$ is multiplied by the magnitude of the gain of the output amplifier 2 due to the well-known Miller effect (the buffer amplifier 3 has, as mentioned above, unity voltage gain). In other words, since the phase-compensating loop circuit includes the output amplifier 2, and the capacitance of the capacitor $C_C$ is increased by the gain of the output amplifier 2, the area occupied by the capacitance $C_C$ on a semiconductor substrate of an integrated circuit of the operational amplifier can be very small.

In Fig. 2, which is a Bode diagram illustrating characteristics of an operational amplifier, a curve $C_1$ shows a gain-frequency characteristic and a curve $C_2$ shows a phase-frequency characteristic. The horizontal axes of Fig. 2 designate frequency f in a logarithmic scale, and the vertical axes designate gain G in a decibel scale and phase angle $_\phi$ in degrees. The curve $C_1$ designates the gain-frequency characteristic by using straight lines for approximation. The curve has break points $P_1$ and $P_2$, known as poles. The gain characteristic designated by the curve $C_1$ decreases with a negative slope of 6 dB per octave after the first pole $P_1$, and with a negative slope of 12 dB per octave after the second pole $P_2$. Of course, a third or fourth order system has also a third pole or a fourth pole. The maximum phase lag of first, second and third order lag system is 90°, 180° and 270°, respectively, and correspondingly for higher order systems.

Assume that the curves $C_1$ and $C_2$ designate characteristics of a negative feedback amplifier. In such an amplifier, if the phase lag $_{\phi S}$ at a frequency $f_0$ at which the curve $C_1$ crosses the horizontal axis (i.e. the gain of the negative feedback amplifier is equal to zero dB) is less than 180°, the negative feedback amplifier does not oscillate by itself. However, if the phase lag $_{\phi S}$ at the frequency $f_0$ is larger than 180°, the negative feedback amplifier may oscillate by itself, because in such a condition the negative feedback becomes positive feedback. Of course, the second order lag system does not oscillate by itself, because the maximum phase lag of the second order lag system is 180°. However, in a practical feedback amplifier such as the operational amplifier of Fig. 1A or Fig. 1B where the amplifier is a third or fourth or higher order system, there is a possibility of causing self-oscillation. The phase-compensating capacitor $C_C$ of the operational amplifier of Fig. 1A or Fig. 1B operates so as to decrease the high-frequency gain as shown by a curve $C'_1$ designated by a dotted line, and self-oscillation of the operational amplifier can be prevented. A curve $C'_2$ designated by a dotted line shows a phase-frequency characteristic corresponding to the curve $C'_1$.

As is well known, the signal delay in a circuit influences the gain characteristic and the phase characteristic thereof, and a cut-off frequency of the circuit at which the gain of the circuit becomes 0 dB is approximately inversely proportional to the signal delay time of the circuit. Therefore, in the conventional operational amplifier of Fig. 1A or Fig. 1B in which the signal delay time $t_1$ of the output amplifier 2 is shorter than or equal to the signal delay time $t_2$ of the phase compensating circuit, i.e. $t_1 \leq t_2$, the cut-off frequency $f_1$ of the output amplifier 2 is higher than or equal to the cut-off frequency $f_2$ of the phase-compensating circuit, i.e. $f_1 \geq f_2$. This means that there is a frequency range in which the phase-compensating circuit does not operate, even though the output amplifier 2 is still operable, i.e. the output amplifier 2 has a gain greater than 0 dB. Therefore, in the above-mentioned frequency range, the gain of the output amplifier undesirably increases and there is a possibility of causing self-oscillation of the amplifier. Since the output amplifier 2 does not operate at higher frequencies than $f_1$, the above-mentioned frequency range coincides with the range between $f_2$ and $f_1$, and undesirable signals and/or noise in this frequency range appear at the output terminal $V_{OUT}$ of the output amplifier 2. Usually the cut-off frequency of the differential circuit 1 is lower than the cut-off frequency $f_2$ of the phase-compensating circuit, and thus the signal source of the undesirable signals and/or noise is not an input signal circuit connected to the operational amplifier, but an operating voltage source of the operational amplifier. Therefore, in the conventional operational amplifier, the SVRR cannot be small enough and, when high frequency noise is superposed on the operating voltage, the noise appears at the output terminal $V_{OUT}$.

Fig. 3A and Fig. 3B illustrate operational amplifiers in accordance with the present invention. In these figures,the same parts as appear in Figs. 1A and 1B are designated by the same reference numbers, and a detailed explanation thereof ie omitted here. The operational amplifier of Fig. 3A comprises a differential circuit 1, an output amplifier 2, a phase-compensating capacitor $C_C$ and an inverting amplifier 4.

The operational amplifier of Fig. 3A differs from that of Fig. 1A or Fig. 1B in that the phase-compensating circuit is not constituted by using the output amplifier 2, but is constituted by using another inverting amplifier 4 the input terminal of which is connected to the output terminal of the differential circuit 1, and the output terminal of which is connected through the phase-compensating capacitor $C_C$ to the same output terminal of the differential circuit 1. The inverting amplifier 4 has, for example, the same circuit structure as that of the output amplifier 2, and has a smaller signal delay time $t'_2$ than the signal delay time $t_1$ of the output amplifier 2, i.e. $t_1 > t'_2$. In order to gain such a difference in the delay time, for example the drive capacity of the output amplifier 2 is denreased by making the load of the output amplifier 2 relatively heavy and/or by making the size of the transistors of the output amplifier 2 relatively small. It is also preferable to increase the drive capacity of the inverting amplifier 4 of the phase-compensating circuit by decreasing the load of the inverting amplifier 4 and/or by increasing the size of the transistors of the inverting amplifier 4.

The operational amplifier of Fig. 3A operates as follows. The differential circuit 1 produces, at an output terminal P thereof, an output signal corresponding to the difference between input signals applied to the non-inverting input terminal $V_{IN}(+)$ and to the inverting input terminal $V_{IN}(-)$. The output signal from the differential circuit 1 is applied to, and amplified by, the output amplifier 2 which produces an output signal of the operational amplifier at the output terminal $V_{OUT}$. In Fig. 3A, since the phase-compensating capacitor $C_C$ is connected between the input and ouput terminals of the inverting amplifier 4, and the input terminal of the inverting amplifier 4 is connected to the output terminal P of the differential circuit 1, the equivalent load capacitance of the differential circuit 1 is approximately equal to the capacitance of the capacitor $C_C$ multiplied by the magnitude of the gain of the inverting amplifier 4 due to the Miller effect. The equivalent load capacitance of the differential circuit 1 decreases the high-frequency gain and prevents self-oscillation of the operational amplifier.

In the structure of Fig. 3A, the signal delay time $t'_2$ of the inverting amplifier 4 is smaller than the signal delay time $t_1$ of the output amplifier 2, and thus the cut-off frequency $f_1$ of the output amplifier 2 is lower than the cut-off frequency $f'_2$ of the phase-compensating circuit, i.e. $f_1 < f'_2$. Therefore, the phase-compensating circuit operates over the whole frequency range in which the output amplifier 2 operates. As a result, even when noise having higher frequencies than the cut-off frequency $f'_2$ of the phase-compensating circuit are superposed on the operating voltage, the high-frequency noise is not amplified and does not appear at the output terminal $V_{OUT}$, so that the SVRR can be very small.

The operational amplifier of Fig. 3B has the same structure as that of Fig. 3A except that an output amplifier stage is constituted by a high-gain inverting amplifier 2a and a buffer amplifier 2b used for impedance matching. The operation of the operational amplifier of Fig. 3B is approximately the same as that explained above with regard to the operational amplifier of Fig. 3A.

Fig. 4 illustrates a detailed circuit of the operational amplifier of Fig. 3A which is constituted by MOS field effect transistors and which is operated by a positive operating voltage source $+V_S$ and a negative operating voltage source $-V_S$. In Fig. 4, transistors $T_1$ to $T_5$ make up the differential circuit 1, transistors $T_6$ and $T_7$ make up the output amplifier 2, and transistors $T_8$ and $T_9$ make up the inverting amplifier 4 of the phase-compensating circuit. The transistor $T_1$ of the differential circuit 1 constitutes a constant current source, the gate electrode of which is supplied with a control voltage $V_A$. The transistors $T_2$ and $T_3$ have the same size, i.e. the same channel length and the same channel width, so that these transistors $T_2$ and $T_3$ have the same electrical characteristics. The transistors $T_4$ and $T_5$ also have the same size and the same electrical characteristics. The transistors $T_2$ and $T_3$ detect the voltage difference between the input voltages applied to the non-inverting input terminal $V_{IN}(+)$ and the inverting input terminal $V_{IN}(-)$ and generate an output voltage $V_E$ at the drain electrode of the transistor $T_3$. The diode-connected transistor $T_4$ determines the centre value of the output voltage $V_E$, which is equal to the centre value of a voltage $V_D$ at the drain electrode of the transistor $T_4$.

The transistor $T_6$ of the output amplifier 2 constitutes a constant current source, the gate electrode of which is supplied with a control voltage $V_C$. The transistor $T_7$ is a driver transistor which amplifies the output voltage $V_E$ from the differential circuit 1 and which operates in the saturation region of the drain current. The transistor $T_8$ of the inverting amplifier 4 constitutes a constant current source, the gate electrode of which is supplied with a control voltage $V_B$, and the transistor $T_9$ is a driver transistor which amplifies the output voltage $V_E$ from the differential circuit 1 and drives the phase-compensating capacitor $C_C$.

It is preferable to set the size of the transistors $T_6$ and $T_7$ of the output amplifier 2 and the transistors $T_8$ and $T_9$ so as to satisfy the following relationships.

$$W8/L8 = kW6/L6 \quad (1)$$

$$W9/L9 = kW7/L7 \quad (2)$$

where W9 to W6 designate the channel width of the transistors $T_9$ to $T_6$, L9 to L6 designate the channel length of the transistors $T_9$ to $T_6$ and k is a constant. In order to make the drive capacity of the inverting amplifier 4 larger than that of the output amplifier 2 and to make the delay time of the inverting amplifier 4 shorter than that of the output amplifier 2, the constant k in the equations (1) and (2) is made greater than 1. When the sizes of the transistors $T_6$ to $T_9$ are set so as to satisfy the equation (1) and (2), the design of the circuit patterns of the operational amplifier becomes simple.

In the circuit of Fig. 4, since the transistor $T_4$ of the differential circuit 1 is diode-connected and has a high response speed, the high-frequency noises superposed on the power supply voltage $-V_S$ are delivered to the node $V_D$ of Fig. 4 in the same phase, even when the frequencies of the high-frequency noises are higher than the aforementioned cut-off frequency $f_1$ of the output amplifier 2. In order to suppress the appearance of the high-frequency noises at the output terminal $V_{OUT}$ of the operational amplifier, it is necessary that the output signal $V_E$ of the differential circuit 1 is changed in the same phase according to the high-frequency noises on the power supply voltage $-V_S$. The phase-compensating circuit is used for this purpose.

As mentioned before, the cut-off frequency $f'_2$ of the inverting amplifier 4 is higher than the cut-off frequency $f_1$ of the output amplifier 2 and, therefore, the delay time $t'_2$ of the inverting amplifier 4 is shorter than the delay time $t_1$ of the output amplifier 2. Therefore, the variation of the potential of the node $V_E$ affects firstly the potential of the output node $V_F$ of the inverting amplifier 4, rather than the potential of the output terminal $V_{OUT}$. When the potential difference between the node $V_E$ and the negative voltage source $-V_S$ becomes small, the gate potential of the transistor $T_9$ falls, and the potential of the node $V_F$ rises so as to conduct a constant current determined by the transistor $T_8$. The rise in potential of the node $V_F$ is delivered through the capacitor $C_C$ to the node $V_E$ of the differential circuit 1, and the fall in potential of the node $V_E$ is suppressed. On the other hand, when the potential difference between the node $V_E$ and the voltage source $-V_S$ becomes large, the potential of the node $V_F$ falls and the rise in potential of the node $V_E$ is suppressed. Therefore, the potential difference between the node $V_E$ and the negative voltage source $-V_S$ is kept at a constant value and the high-frequency noises do not appear at the output terminal $V_{OUT}$ in the operating frequency range of the phase-compensating circuit which is lower than the cut-off frequency $f'_2$ thereof. In a frequency range higher than the cut-off frequency $f_1$ of the output amplifier 2, the high-frequency noises do not appear at the output terminal $V_{OUT}$ because in such a frequency range the output amplifier 2 does not operate. Therefore, since the cut-off frequency $f'_2$ is higher than the cut-off frequency $f_1$, the high-frequency noises from the operating voltage source do not appear at the output terminal $V_{OUT}$ of the operational amplifier at any frequency and the SVRR can be very small.

According to the present invention, it is not necessary to use high-precision ripple filter circuits connected to the operating voltage terminals of the operational amplifier, and the SVRR of the operational amplifier can be very small, even when the operational amplifier is combined with digital circuits in a hybrid-type integrated circuit device.

**Claims**

1. An operational amplifier, comprising a differential circuit (1) having a non-inverting input $V_{IN}(+)$, an inverting input $V_{IN}(-)$ and an output terminal and which detects the potential difference ($V_E$) between input signals applied to the non-inverting input and the inverting input; an output amplifier (2) the input of which is connected to the output of the differential circuit (1); characterised by an inverting amplifier (4) of a phase compensating circuit (4, $C_C$) the input of which is connected to the output of the differential circuit (1); and a phase-compensating capacitor ($C_C$) connected between the output of the inverting amplifier (4) and the output of the differential circuit (1), the signal delay time ($t'_2$) of the inverting amplifier (4) being shorter than that ($t_1$) of the output amplifier (2).

2. An operational amplifier as claimed in Claim 1, characterised in that the differential circuit (1) comprises a constant current source circuit ($T_1$), a pair of differential transistors ($T_2$, $T_3$) and a pair of load transistors ($T_4$, $T_5$).

3. An operational amplifier as claimed in Claim 2, characterised in that the pair of differential transistors ($T_2$, $T_3$) are field effect transistors the source electrodes of which are connected in common to the constant current source circuit ($T_1$).

4. An operational amplifier as claimed in Claim 2 or Claim 3, characterised in that the constant current source circuit ($T_1$) comprises a field effect transistor which is operated in the saturation region of the drain current.

5. An operational amplifier as claimed in any one of Claims 2 to 4, characterised in that the pair of differential transistors ($T_2$, $T_3$) have approximately the same electrical characteristics.

6. An operational amplifier as claimed in any one of Claims 2 to 5, characterised in that the pair of load transistors ($T_4$, $T_5$) are field effect transistors, one of which ($T_4$) is a diode-connected transistor.

7. An operational amplifier as claimed in any one of Claims 2 to 6, characterised in that the pair of load transistors ($T_4$, $T_5$) have approximately the same electrical characteristics.

8. An operational amplifier as claimed in any preceding claim, characterised in that the output amplifier (2) comprises a drive transistor ($T_7$) and a constant current source circuit ($T_6$) connected in a load circuit of the drive transistor.

9. An operational amplifier as claimed in Claim 8, characterised in that the drive transistor ($T_7$) is a field effect transistor.

10. An operational amplifier as claimed in Claim 8 or Claim 9, characterised in that the constant current source circuit ($T_6$) of the output amplifier (2) comprises a field effect transistor which is operated in the saturation region of the drain current.

11. An operational amplifier as claimed in any preceding claim, characterised in that the inverting amplifier (4) of the phase-compensating circuit comprises a drive transistor ($T_9$) and a constant current source circuit ($T_8$) inserted in a load circuit of the drive transistor.

12. An operational amplifier as claimed in Claim 11, characterised in that the drive transistor ($T_9$) of the inverting amplifier (4) is a field effect transistor.

13. An operational amplifier as claimed in Claim 11 or Claim 12, characterised in that the constant current source circuit ($T_8$) of the inverting amplifier (4) comprises a field effect transistor which is operated in the saturation region of the drain current.

14. An operational amplifier as claimed in any preceding claim, characterised in that the output amplifier (2) comprises a high gain amplifier section (2a) and a buffer amplifier section (2b).

15. An operational amplifier as claimed in Claim 1, characterised in that the output amplifier (2) and the inverting amplifier (4) have the same circuit structure.

**Patentansprüche**

1. Operationsverstärker, mit einer Differentialschaltung (1), welche einen nichtinvertierenden Eingang $V_{IN}(+)$, einen invertierenden Eingang $V_{IN}(-)$ und einen Ausgangsanschluß umfaßt und welche die Potentialdifferenz ($V_E$) zwischen den Eingangssignalen detektiert, die dem nicht-invertierenden Eingang und dem invertierenden Eingang zugeführt werden, und mit einem Ausgangsverstärker (2), dessen Eingang mit dem Ausgang der Differentialschaltung (1) verbunden ist, gekennzeichnet durch einen invertierenden Verstärker (4) einer Phasenkompensationsschaltung (4, $C_C$), deren Eingang mit dem Ausgang der Differentialschaltung (1) verbunden ist, und durch einen Phasenkompensationskondensator ($C_C$), welcher zwischen dem Ausgang des invertierenden Verstärkers (4) und dem Ausgang der Differentialschaltung (1) geschaltet ist, wobei die Signalverzögerungszeit ($t'_2$) des invertierenden Verstärkers (4) kürzer als diejenige ($t_1$) des Ausgangsver-stärkers (2) ist.

2. Operationsverstärker nach Anspruch 1, dadurch gekennzeichnet, daß die Differentialschaltung (1) eine Konstantstromquellenschaltung ($T_1$), ein Paar von Differentialtransistoren ($T_2$, $T_3$) und ein Paar von Lasttransistoren ($T_4$, $T_5$) umfaßt.

3. Operationsverstärker nach Anspruch 2, dadurch gekennzeichnet, daß das Paar von Differentialtransistoren ($T_2$, $T_3$) Feldeffekttransistoren sind, deren Source-Elektroden gemeinsam mit der Konstantstromquellenschaltung ($T_1$ verbunden sind.

4. Operationsverstärker nach Anspruch 2 oder 3, dadurch gekennzeichnet, daß die Konstantstromquellenschaltung ($T_1$) einen Feldeffekttransistor umfaßt, welcher im Sättigungsbereich des Drainstromes betrieben wird.

5. Operationsverstärker nach einem der Ansprüche 2 bis 4, dadurch gekennzeichnet, daß die beiden Differentialtransistoren ($T_2$, $T_3$) etwa dieselben elektrischen Charakteristiken aufweisen.

6. Operationsverstärker nach einem der Ansprüche 2 bis 5, dadurch gekennzeichnet, daß die beiden Lasttransistoren ($T_4$, $T_5$) Feldeffekttransistoren sind, von denen einer ($T_4$) ein diodenverbundener Transistor ist.

7. Operationsverstärker nach einem der Ansprüche 2 bis 6, dadurch gekennzeichnet, daß die beiden Lasttransistoren ($T_4$, $T_5$) etwa dieselben elektrischen Charakteristiken aufweisen.

8. Operationsverstärker nach einem der vorhergehenden Ansprüche, dadurch gekennzeichnet, daß der Ausgangsverstärker (2) einen Treibertransistor ($T_7$) und eine Konstantstromquellenschaltung ($T_6$) umfaßt, die mit einer Lastschaltung des Treibertransistors verbunden ist.

9. Operationsverstärker nach Anspruch 8, dadurch gekennzeichnet, daß der Treibertransistor ($T_7$) ein Feldeffekttransistor ist.

10. Operationsverstärker nach Anspruch 8 oder 9, dadurch gekennzeichnet, daß die Konstantstromquellenschaltung ($T_6$) des Ausgangsverstärkers (2) einen Feld-effektransistor umfaßt, welcher im Sättigungsbereich des Drainstromes betrieben wird.

11. Operationsverstärker nach einem der vorhergehenden Ansprüche, dadurch gekennzeichnet, daß der invertierende Verstärker (4) der Phasenkompensationsschaltung einen Treibertransistor ($T_9$) und eine in den Lastkreis des Treibertransistors geschaltete Konstantstromquellenschaltung ($T_8$) umfaßt.

12. Operationsverstärker nach Anspruch 11, dadurch gekennzeichnet, daß der Treibertransistor ($T_9$) des invertierenden Verstärkers (4) ein Feldeffekttransistor ist.

13. Operationsverstärker nach Anspruch 11 oder 12, dadurch gekennzeichnet, daß die Konstantstromquellenschaltung ($T_8$) des invertierenden Verstärkers (4) einen Feldeffekttransistor umfaßt, welcher im Sättigungsbereich des Drainstromes betrieben wird.

14. Operationsverstärker nach einem der vorhergehenden Ansprüche, dadurch gekennzeichnet, daß der Ausgangsverstärker (2) einen Verstärkerabschnitt (2a) hoher Verstärkung und einen Pufferverstärkerabschnitt (2b) umfaßt.

15. Operationsverstärker nach Anspruch 1, dadurch gekennzeichnet, daß der Ausgangsverstärker (2) und der invertierende Verstärker (4) dieselbe Schaltungsstruktur aufweisen.

**Revendications**

1. Amplificateur opérationnel, comprenant un circuit différentiel (1) qui possède une entrée de non-inversion $V_{IN}(+)$, une entrée d'inversion $V_{IN}(-)$ et une borne de sortie et qui mesure la différence de potentiel ($V_E$) entre les signaux d'entrée appliqués à l'entrée de non-inversion et à l'entrée d'inversion; un amplificateur de sortie (2) dont l'entrée est connectée à la sortie du circuit différentiel (1); caractérisé par un amplificateur inverseur (4) d'un circuit de compensation de phase (4, $C_C$) dont l'entrée est connectée à la sortie du circuit différentiel (1); et un condensateur de compensation de phase ($C_C$) connecté entre la sortie de l'amplificateur inverseur (4) et la sortie du circuit différentiel (1), le retard ($t'_2$) de l'amplificateur inverseur (4) étant plus court que celui ($t_1$) de l'amplificateur de sortie (2).

2. Amplificateur opérationnel selon la revendication 1, caractérisé en ce que le circuit différentiel (1) comprend un circuit de source à courant constant ($T_1$), une paire de transistors différentiels ($T_2$, $T_3$) et une paire de transistors de charge ($T_4$, $T_5$).

3. Amplificateur opérationnel selon la revendication 2, caractérisé en ce que la paire de transistors différentiels ($T_2$, $T_3$) est formée de transistors à effet de champ dont les électrodes de source sont connectées en commun au circuit de source à courant constant ($T_1$).

4. Amplificateur opérationnel selon la revendication 2 ou 3, caractérisé en ce que le circuit de source à courant constant ($T_1$) comprend un transistor à effet de champ qui fonctionne dans la région de saturation du courant de drain.

5. Amplificateur opérationnel selon l'une quelconque des revendications 2 à 4, caractérisé en ce que les deux transistors différentiels ($T_2$, $T_3$) présentent des caractéristiques électriques approximativement identiques.

6. Amplificateur opérationnel selon l'une quelconque des revendications 2 à 5, caractérisé en ce que la paire de transistors de charge ($T_4$, $T_5$) est formée de transistors à effet de champ dont l'un ($T_4$) est un transistor connecté en diode.

7. Amplificateur opérationnel selon l'une quelconque des revendications 2 à 6, caractérisé en ce que les deux transistors de charge ($T_4$, $T_5$) possèdent des caractéristiques électriques approximativement identiques.

8. Amplificateur opérationnel selon l'une quelconque des revendications précédentes, caractérisé en ce que l'amplificateur de sortie (2) comprend un transistor de commande ($T_7$) et un circuit de source à courant constant ($T_6$) connecté dans un circuit de charge du transistor de commande.

9. Amplificateur opérationnel selon la revendication 8, caractérisé en ce que le transistor de commande ($T_7$) est un transistor à effet de champ.

10. Amplificateur opérationnel selon la revendication 8 ou 9, caractérisé en ce que le circuit de source à courant constant ($T_6$) de l'amplificateur de sortie (2) comprend un transistor à effet de champ qui fonctionne dans la région de saturation du courant de drain.

11. Amplificateur opérationnel selon l'une quelconque des revendications précédentes, caractérisé en ce que l'amplificateur inverseur (4) du circuit de compensation de phase comprend un transistor de commande ($T_9$) et un circuit de source à courant constant ($T_8$) inserré dans un circuit de charge du transistor de commande.

12. Amplificateur opérationnel selon la revendication 11, caractérisé en ce que le transistor de commande ($T_9$) de l'amplificateur inverseur (4) est un transistor à effet de champ.

13. Amplificateur opérationnel selon la revendication 11 ou 12, caractérisé en ce que le circuit de source à courant constant ($T_8$) de l'amplificateur inverseur (4) comprend un transistor à effet de champ qui fonctionne dans la région de saturation du courant de drain.

14. Amplificateur opérationnel selon l'une quelconque des revendications précédentes, caractérisé en ce que l'amplificateur de sortie (2) comprend und section amplificatrice à gain élevé (2a) et une section amplificatrice tampon (2b).

15. Amplificateur opérationnel selon la revendication 1, caractérisé en ce que l'amplificateur de sortie (2) et l'amplificateur inverseur (4) ont la même structure de circuit.

Fig. 1A

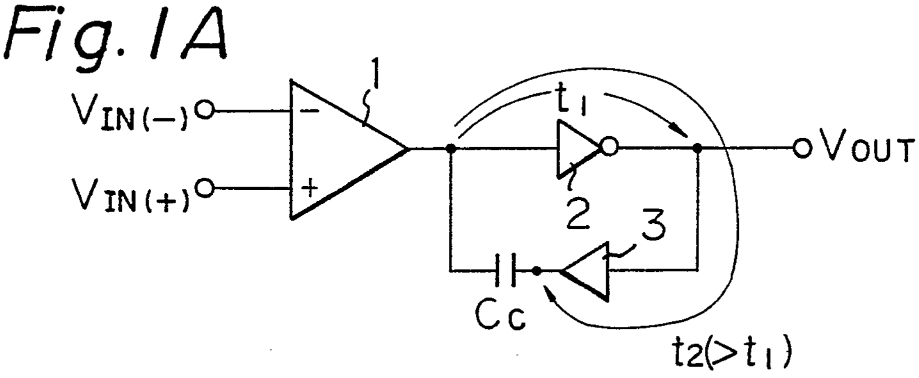


Fig. 1B

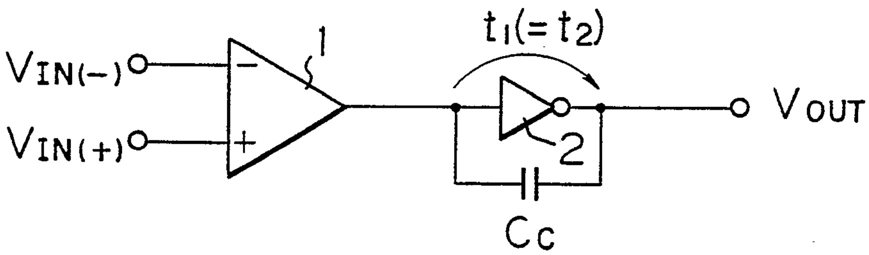


Fig. 3A

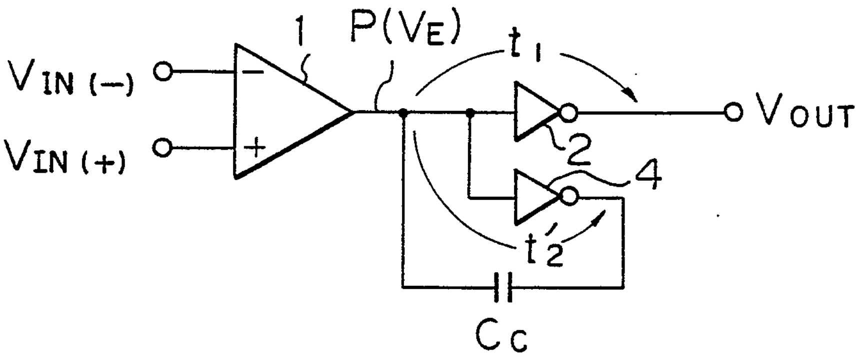


Fig. 3B

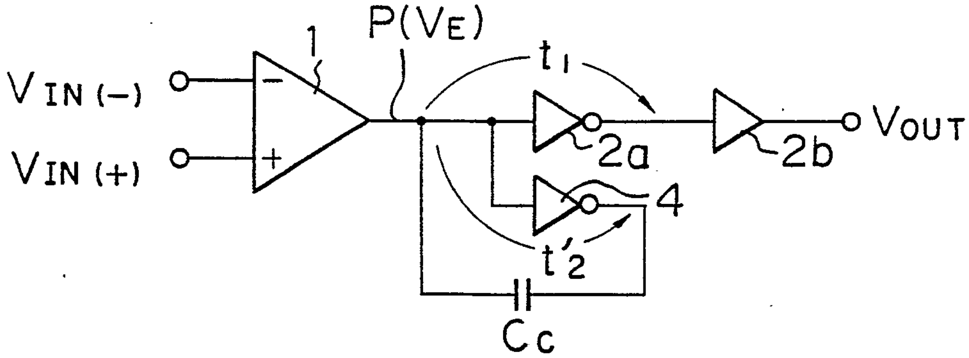

Fig. 2

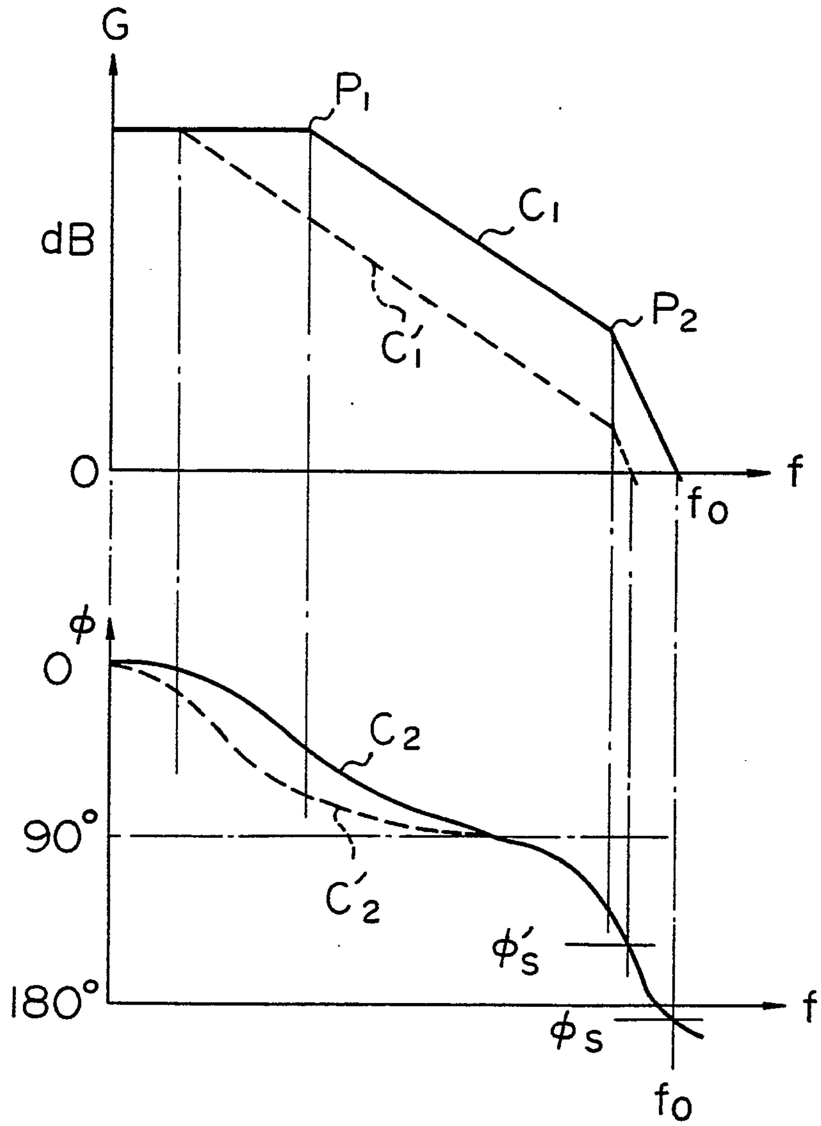

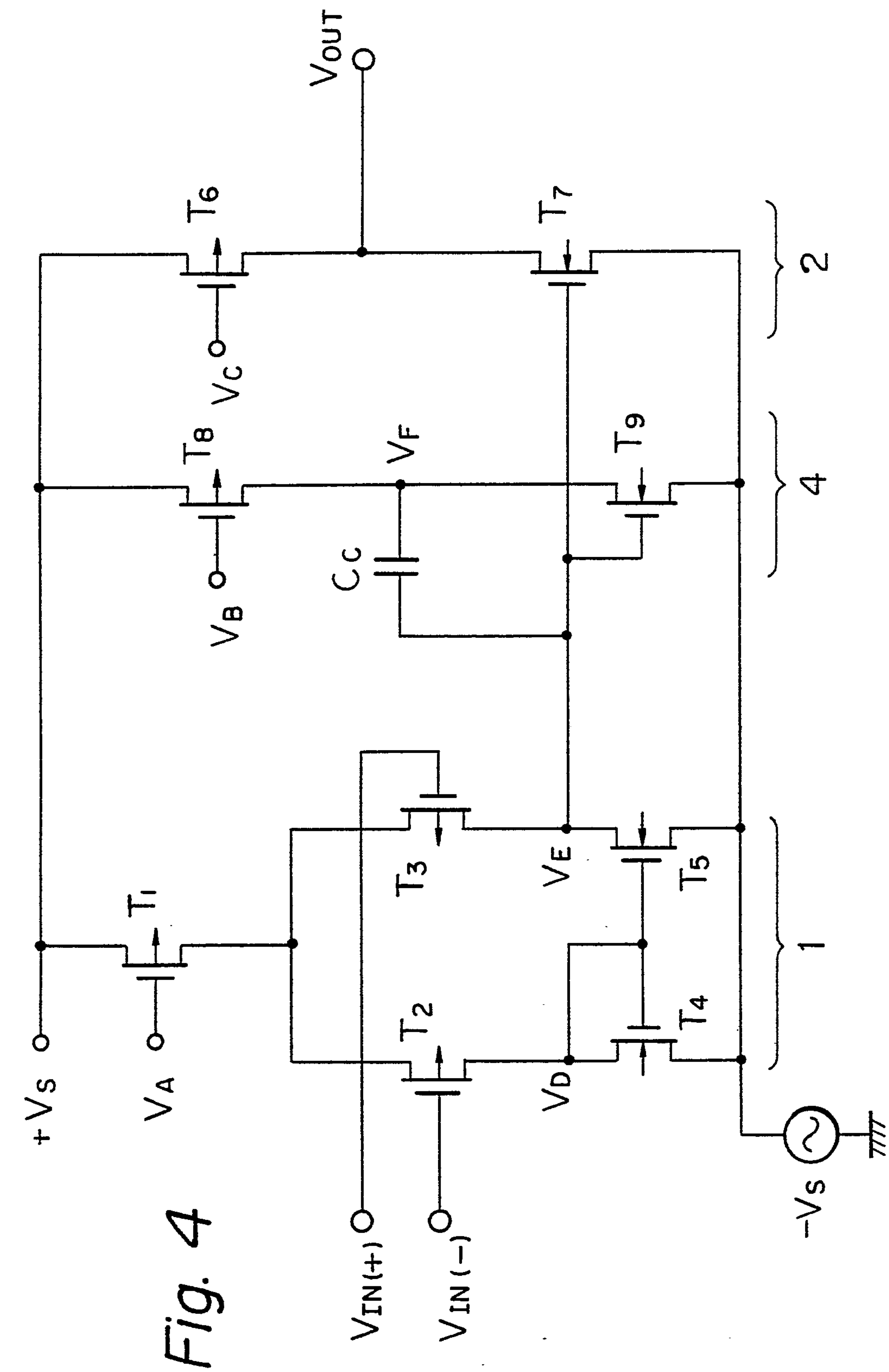


Fig. 4